**Europäisches Patentamt**

**European Patent Office**

**Office européen des brevets**

(19)

(11)  **EP 1 102 100 A2**

(12)  **EUROPÄISCHE PATENTANMELDUNG**

(43)  Veröffentlichungstag:
 **23.05.2001  Patentblatt 2001/21**

(51)  Int Cl.7: **G02B 17/08**

(21)  Anmeldenummer: **00121403.0**

(22)  Anmeldetag: **29.09.2000**

(84)  Benannte Vertragsstaaten:
 **AT BE CH CY DE DK ES FI FR GB GR IE IT LI LU MC NL PT SE**
 Benannte Erstreckungsstaaten:
 **AL LT LV MK RO SI**

(30)  Priorität: **12.11.1999  DE 19954727**
 **27.04.2000  DE 10020592**

(71)  Anmelder:
 • **Carl Zeiss**
  **89518 Heidenheim (Brenz) (DE)**
  Benannte Vertragsstaaten:
  **BE CH DE DK ES FI FR GR IT LU MC NL PT SE AT CY**
 • **Carl-Zeiss-Stiftung, trading as Carl Zeiss**
  **89518 Heidenheim (Brenz) (DE)**
  Benannte Vertragsstaaten:
  **GB IE**

(72)  Erfinder:
 • **Ulrich, Willi**
  **73434 Aalen-Dewangen (DE)**
 • **Beierl, Helmut**
  **89522 Heidenheim (DE)**

(74)  Vertreter: **Dr. Weitzel & Partner**
 **Friedenstrasse 10**
 **89522 Heidenheim (DE)**

(54)  **Katadioptrisches Objektiv mit physikalischem Strahlteiler**

(57)  Die Erfindung betrifft ein katadioptrisches Projektionsobjektiv mit einer Objektebene, einem physikalischen Strahlteiler,
einem Konkavspiegel,
einer Bildebene,
einem ersten Objektivteil, wobei der erste Objektivteil zwischen Objektebene und physikalischem Strahlteiler angeordnet ist,
einem zweiten Objektivteil, wobei der zweite Objektivteil zwischen physikalischem Strahlteiler und Konkavspiegel, angeordnet ist,
einem dritten Objektivteil, wobei der dritte Objektivteil zwischen physikalischem Strahlteiler und der Bildebene angeordnet ist.

Die Erfindung ist dadurch gekennzeichnet, daß der zweite Objektivteil wenigstens zwei Zerstreulinsen umfaßt.

Fig.1

**Beschreibung**

Die Erfindung betrifft ein katadioptrisches Projektionsobjektiv mit einer Objektebene, einem physikalischen Strahlteiler, einem Konkavspiegel, einer Bildebene, einem ersten Objektivteil, einem zweiten Objektivteil, sowie einem dritten Objektivteil.

Für Projektionsbelichtungsvorrichtungen, mit denen Muster von Fotomasken oder Strichplatten, die nachfolgend allgemein als Masken bzw. Retikel bezeichnet werden, auf mit Licht empfindliche Materialien beschichtete Halbleiter-Wafer oder Glasplatten zu projizieren oder zu belichten, verwendet man optische Projektionssysteme höchster Auflösung. Um die Strukturbreite, die im wesentlichen durch die beugungsbegrenzte Auflösung limitiert ist, weiter zu verringern, werden für die Darstellung derartig kleiner Strukturen bevorzugt DUV- und VUV-Strahlen mit einer Wellenlänge von ≤ 260 nm verwendet. Als Projektionsobjektive gelangen für derartige Projektionseinrichtungen u.a. katadioptrische Systeme zur Anwendung. Katadioptrische Systeme erlauben eine große Bandbreite, wodurch die Kosten der Laserbelichtungsquelle gering gehalten werden können und der Wirkungsgrad hoch ist.

Aus der US 5636066 ist ein katadioptrisches Projektionssystem mit Zwischenbild bekanntgeworden. Die Strahlteilung erfolgt geometrisch mit Hilfe eines Umlenkspiegels, der in der Spiegelmitte durchbrochen ist und für den vom katadioptrischen Teil am Hohlspiegel reflektierten Strahl eine Blende darstellt. Das System gemäß der US 5636066 ist derart aufgebaut, daß das Zwischenbild in der Blendenebene des Umlenkspiegels ausgebildet ist.

Ein weiteres System mit geometrischem Strahlteiler, der als Ablenkspiegel ausgeführt ist, ist aus der US-A-5691802 bekannt geworden. Bei dem aus der US-A-5691802 bekannten Projektionsobjektiv handelt es sich um ein solches mit Zwischenbild, wobei das Zwischenbild vor dem katadioptrischen Teilobjektiv im Bereich des ersten Teilobjektives ausgebildet wird. Nachteilig an dem aus der US-A-5691802 bekannten System ist, daß es sich aufgrund der geometrischen Strahlteilung zwingend um ein außeraxiales System handelt.

Ein System mit physikalischem Strahlteiler ist aus der EP-A-0475020 bekannt geworden. Das in der EP-A-0475020 gezeigte System umfaßt wenigstens ein katadioptrisches Eingangssystem sowie ein dioptrisches Ausgangssystem. Die abzubildende Maske liegt direkt auf einem Strahlteiler, vorzugsweise einem Würfel, auf. Mit Hilfe des Strahlteilers wird ein Teil des vom katadioptrischen System reflektierten Lichtes zum dioptrischen System abgelenkt.

Nachteilig an der Anordnung gemäß der EP-A-0475020 ist, daß das abzubildende Objekt direkt auf dem Strahlteiler angeordnet ist und die Korrektion des Zwischenbildes die Möglichkeiten der Korrektion des Gesamtsystems einschränkt.

Bei der US-A-4302079 handelt es sich um ein System mit polarisationsoptischem Strahlteiler. Die Änderung der Polarisationsrichtung des von dem Konkavspiegel im katadioptrischen Objektivteil reflektierten Strahles wird mit Hilfe von induzierter Doppelbrechung geändert.

Die US-A-4896952 zeigt ein System mit polarisationsoptischem Strahlteiler, wobei die Änderung der Polarisationsrichtung in katadioptrischem Objektivteil mittels einer λ/4-Platte erreicht wird.

Die DD-C-215179 zeigt ebenfalls ein System mit physikalischem Strahlteiler, der als teildurchlässiger Strahlteilerwürfel ausgebildet ist. Das System gemäß der DD-C-215179 weist zwei identische Spiegel an zwei der vier Seiten des Strahlteilerwürfels senkrecht zu einer vorgegebenen Ebene sowie zwei dioptrische Baugruppen an den anderen zwei Seiten des Strahlteilerwürfels auf. Die dioptrischen Baugruppen sind so ausgeführt, daß die Petzvalsumme von beiden Systemen die des Spiegels weitgehend kompensiert.

Aus der EP-A-0350955 ist ein katadioptrisches Projektionsobjektiv ohne Zwischenbild bekannt geworden, bei dem zwischen Objekt - dem Retikel-und dem physikalischen Strahlteiler eine erste Linsengruppe bzw. ein erstes Teilobjektiv, zwischen physikalischem Strahlteiler und Hohlspiegel eine zweite Linsengruppe und zwischen physikalischem Strahlteiler und der Bildebene eine dritte Linsengruppe vorgesehen ist.

Die US-A-5808805 und die US-A-5999333 zeigen ein katadioptrisches Objektiv mit Zwischenbild und Strahlteiler sowie wenigstens zwei Teilobjektiven, wobei die Teilobjektive derart aufgebaut sind, daß das Zwischenbild in der Nähe der Strahlteilerfläche des physikalischen Strahlteilers zu liegen kommt. Als Strahlteiler wird gemäß der US 5808805 ein physikalischer Strahlteiler, beispielsweise ein Strahlteilerwürfel, verwandt; die US 5999333 zeigt auch die Verwendung eines Spiegels als geometrischen Strahlteiler.

Nachteilig an dem System mit geometrischer Strahlteilung ist, daß es sich hierbei um ein außeraxiales System handelt. Sowohl das aus der US-A-5808805 bekannte System wie das aus der US-A-5999333 weisen einen sehr großen Inzidenzwinkelbereich der auf die Strahlteilerfläche auftreffenden vom Konkavspiegel reflektierten rücklaufenden Strahlen auf.

Die US-A-5861997 zeigt ein System ähnlich der US-A-5808805 sowie der US-A-5999333 mit zwei Zwischenbildern, wobei ein Zwischenbild wiederum in der Nähe des Strahlteilers zum Liegen kommt, so daß am Strahlteiler große Inzidenzwinkel auftreten.

Der entscheidende Nachteil der aus der US-A-4302079, der US-A-4896952, der EP-A-0350955, der DD-C-215179, der US-A-5808805, der US-A-5861997 sowie der US-A-5999333 bekannten Anordnungen ist somit, daß die auf die Strahlteilerschicht auftreffenden Strahlen einen großen Winkelbereich aufweist. Dies gilt insbesondere für die in der US-A-5808805, der US-A-5861997 und der US-A-5999333 gezeigte Ausführungsform, bei der das Zwischenbild in der Nähe der Strahlteilerfläche ausgebildet wird.

Durch den großen Winkelbereich,der auf die Strahlteilerschicht auftreffenden Strahlung wird die Bildqualität verringert, da die Reflektivität und die Transmission der Strahlteilerschicht vom Einfallswinkel auf die Strahlteilerschicht abhängen und insoweit bei unterschiedlichen Einfallswinkeln unterschiedliche Intensitätsverteilungen resultieren.

Um diesen Nachteil zu vermeiden, schlägt die EP-A-0602923 vor, vor den physikalischen Strahlteilern eine Linse vorzusehen, mit der die auf dem Strahlteiler auftreffende Strahlung parallelisiert wird.

Ein parallelisierter Strahlengang wird auch bei dem aus der US-A-5771125 bekannten katadioptrischen Projektionssystem realisiert. Nachteilig an der Anordnung gemäß der EP-A-0602923 und der US-A-5771125 ist, daß die positive Brechkraft des Spiegels im katadioptrischen Teil nicht kompensiert wird. Dies bedeutet, daß zwar der auf die Strahlteilerschicht auftreffende Strahl parallelisiert ist, nicht jedoch der nach der Reflexion am Konkavspiegel rücklaufende Strahl. Die Strahlteilerschicht wird dann in einer Richtung unter größeren Aperturwinkeln belastet. Dies wiederum hat zur Folge, daß keine reine Aufspaltung in die Polarisationsrichtungen erfolgen kann. Hieraus resultieren Doppelbilder und ein Kontrastverlust.

Um die Indizenzwinkel auf der Strahlteilerschicht zu minimieren, schlägt die DE-A-4417489 vor, bei einem katadioptrischen Projektionssystem mit physikalischen Strahlteiler objektseitig vor dem physikalischen Strahlteiler wenigstens eine Sammellinse zur Parallelisierung des auf die Strahlteilerschicht auftreffenden Lichtstrahles anzuordnen und nach dem physikalischen Strahlteiler im katadioptrischen Objektivteil eine zerstreuende Linsengruppe mit einer Zerstreulinse, um die Wirkung der Sammellinse zur Parallelisierung des auf die Strahlteilerschicht auftreffenden Strahles zu kompensieren. Des weiteren ist eine weitere Sammellinse bildseitig nach dem Strahlteilerprisma vorgesehen, um die Wirkung der zerstreuenden Linsengruppe bei einem von dem Konkavspiegel zurücklaufenden Strahl im doppelten Durchtritt zu kompensieren.

Nachteilig an der Anordnung gemäß der DE-A-4417489 ist, daß die Korrektur des Farblängsfehlers (CHL) durch den überkorrigierenden katadioptrischen Objektivteil nicht ausreichend ist.

Eine erste Aufgabe der Erfindung ist es daher, ein katadioptrisches Projektionsobjektiv anzugeben, das die Nachteile der DE-A-4417489 überwindet und insbesondere die vollständige Korrektur des Farblängsfehlers ermöglicht.

Erfindungsgemäß wird diese Aufgabe in einer ersten Ausgestaltung durch ein Projektionssystem gelöst, bei dem im 2. Objektivteil zwischen Strahlteiler und Konkavspiegel mehr negative Brechkraft angeordnet wird. Eine Aufspaltung dieser starken negativen Brechkraft in mindestens zwei Negativlinsen ist vorteilhaft.

In einer alternativen Ausgestaltung wird der zweite Objektivteil bezüglich der chromatischen Längsaberration CHL überkorrigiert und der erste und dritte Objektivteil unterkorrigiert und die Überkorrektur des zweiten Objektivteils im doppelten Durchgang kompensiert die Unterkorrektur des ersten und dritten Objektivteils zu mindestens 70 % vorzugsweise zu mehr als 85 %.

Die Vorteile eines derartigen Projektionsobjektivs sind:

- die Korrektur des Farblängsfehlers ist nicht mehr limitiert
- der Arbeitsabstand sowohl zwischen Objektebene und erstem Objektivteil sowie zwischen drittem Objektivteil und der Bildebene ist für eine Anwendung in der Mikrolithographie ausreichend
- auf der Strahlteilerfläche wird ein doppelt paralleler Strahlengang sowohl beim Durchtritt zum Konkavspiegel wie auch beim Rücklauf vom Konkavspiegel realisiert
- das gesamte System kann on-axis aufgebaut werden
- bei Ausführung mit Zwischenbild, kann im dritten Objektivteil eine konjugierte, zugängliche Blendenebene vorgesehen werden.

In einer ersten Ausgestaltung des optischen Systems ist vorgesehen, daß die Zerstreulinsen des zweiten Objektivteiles räumlich voneinander getrennt sind.

Als physikalischer Strahlteiler findet bevorzugt ein polarisationsoptischer Strahlteiler mit polarisationsabhängig reflektierendem Schichtsystem Verwendung. Auch die Verwendung schräggestellter Planplatten wäre möglich.

Besonders bevorzugt ist es, wenn der physikalische Strahlteiler annähernd würfelförmig ausgebildet ist, d.h. das Seitenverhältnis $A_1:B_1$ der zum Objekt zeigenden Fläche des physikalischen Strahlteiler im Bereich $0,7 < A_1:B_1 \leq 1.0$ ist sowie das Seitenverhältnis $A_2:B_2$ der zum Wafer zeigenden Fläche ebenfalls im Bereich $0,7 < A_2:B_2 \leq 1.0$ liegt.

Eine besonders gute Abbildungsqualität wird erreicht, wenn der zweite Objektivteil und der Konkavspiegel sowie der physikalische Strahlteiler nahe der Systemapertur angeordnet werden.

Ist das System als System mit Zwischenbild ausgestaltet, so weist vorteilhafterweise der gesamte Objektivteil vom Objekt bis zum Zwischenbild, also erster sowie zweiter Objektivteil und Konkavspiegel im doppelten Durchtritt und dritter Objektivteil bis zum Zwischenbild einen Abbildungsmaßstab $\beta_{zm}$ von $1 \pm 0,7$, bevorzugt 1,5 auf.

Um den Hauptstrahl auf den Scheitel des Konkavspiegels zu fokussieren, ist mit Vorteil vorgesehen, daß das erste Teilobjektiv eine Feldlinse umfaßt.

Eine Reduzierung der Baulänge des Objektives ergibt sich, wenn ein oder mehrere Umlenkspiegel vorgesehen werden. Bevorzugt wird ein Umlenkspiegel nach dem physikalischen Strahlteiler im dritten Objektivteil angeordnet. Durch das Einbringen eines Umlenkspiegels werden vorteilhafterweise Retikel und Wafer parallelisiert. Eine Verringerung der Linsenzahl im Bereich des dritten Objektivteils kann erreicht werden, wenn im dritten Objektivteil asphärische Flächen vorgesehen werden. Dies gilt auch für den zweiten Objektivteil und den ersten Objektivteil umfassend die Feldlinse. Auch eine Anordnung des Umlenkspielgels im ersten Objektivteil wäre möglich.

In einer besonders vorteilhaften Ausgestaltung ist vorgesehen, daß das katadioptrische Projektionsobjektiv mit Zwischenbild ausgebildet ist und eine Teleskopanordnung mit einer Sammellinse im ersten Objektivteil vor dem physikalischen Strahlteiler, einer Zerstreulinse und einem Sammelobjektiv nach dem physikalischen Strahlteiler im dritten Objektivteil und vor dem Zwischenbild aufweist, um eine weitgehende Parallelisierung der auf die Strahlteilerschicht auftreffenden Strahlung zu erreichen.

Die Erfindung soll nachfolgend anhand der Abbildungen beispielhaft beschrieben werden.

Es zeigen:

Figur 1        einen Ausschnitt eines katadioptrischen Objektivs wie in Fig.2a gezeigt im Bereich des Strahlteilers

Figur 2a       ein Ausführungsbeispiel eines katadioptrischen Objektives mit Zwischenbild und drittem Objektivteil, der als Reduktionsobjektiv ausgebildet ist

Figur 2b       eine Ausführungsform eines katadioptrischen Objektives mit Zwischenbild und Umlenkspiegel

Figur 3a bis 3c    die longitudinale sphärische Aberration, den astigmatischen Feldverlauf und die Verzeichnung des Ausführungsbeispieles gemäß Figur 2a.

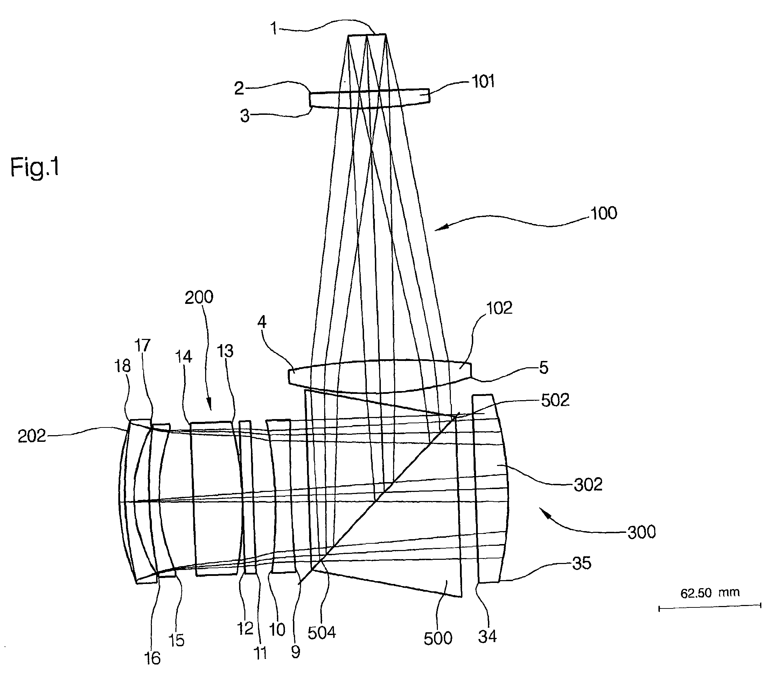

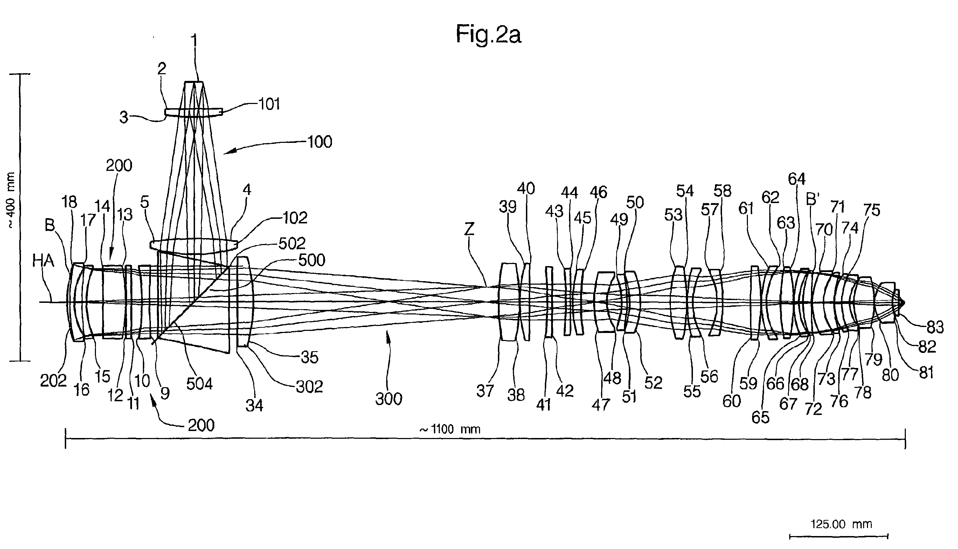

In Figur 1 ist ein Ausschnitt des in Figur 2a vollständig dargestellten katadioptrischen Projektionsobjektives gezeigt und zwar der erste Objektivteil 100 umfassend Sammellinsen 101, 102 mit Flächen 2, 3, 4, 5; das Strahlteilerprisma 500; der zweite Objektivteil 200 umfassend drei Zerstreulinsen sowie zwei Sammellinsen mit Flächen 9, 10, 11, 12, 13, 14, 15, 16, 17, 18 im ersten Durchtritt sowie Flächen 20, 21, 22, 23, 24, 25, 26, 27, 28, 29 im zweiten Durchtritt; der Konkavspiegel 202 mit Fläche 19, der nicht zum zweiten Objektivteil zählt sowie die vor dem Zwischenbild angeordnete Sammellinse 302 des dritten Objektivteiles 300 mit Flächen 34, 35.

Die Sammellinse 102 im ersten Objektivteil 100 dient dazu, die vom Objekt 1 einlaufenden Strahlen weitgehend zu parallelisieren, so daß im Bereich der Strahlteilerschicht 502 nur eine geringe Variation der Inzidenzwinkel der auftreffenden Strahlen 504 vorliegt. Die refraktiven Elemente im zweiten Objektivteil sorgen mit ihrer zerstreuenden Wirkung dafür, daß die Wirkung der Sammellinse 102, die in der Parallelisierung der auf die Strahlteilerschicht 504 auftreffenden Strahlung liegt, weitgehend kompensiert wird und daß ein divergentes Strahlbündel auf den Konkavspiegel 202 trifft.

Das Strahlteilerprisma ist bevorzugt ein polarisationsoptisches Strahlteilerprisma 500, d.h. das einfallende Licht ist beispielsweise p-polarisiert. Das vom Konkavspiegel 202 reflektierte Licht durchdringt beim Zurücklaufen ein Mittel zum Drehen der Polarisation, beispielsweise ein $\lambda/4$-Plättchen, und weist nunmehr beispielsweise s-Polarisation auf, die von der polarisationsoptischen Strahlteilerschicht 504 nicht reflektiert, sondern transmittiert wird. Die an der polarisationsoptischen Strahlteilerschicht 504 transmittierten Strahlen gelangen in den dritten Objektivteil, von dem in Figur 1 nur die Sammellinse 302 vor dem Zwischenbild gezeigt ist. Die Reihenfolge von reflektierender transmittierender Strahlteilerschicht kann auch umgekehrt werden. Um die Wirkung der zerstreuenden Gruppe mit den Linsenflächen 10, 15 und 17 im zweiten Objektivteil beim Rücklauf nach Reflexion am Konkavspiegel 202 zu kompensieren, ist vor dem Zwischenbild im dritten Objektivteil wenigstens eine Sammellinse 302 vorgesehen. Durch eine derartige Anordnung wird die Winkelbelastung auf der Strahlteilerschicht 504, d.h. die Variation der Inzidenzwinkel sowohl beim Hinlauf vom Objekt 1 zum Konkavspiegel 202 wie beim Rücklauf vom Konkavspiegel 202 zum Bild 1000 gering gehalten. Der Absolutbetrag der Brechkraft des zweiten Objektivteils 200 beträgt bevorzugt 40 - 80 % der Brechkraft des Konkavspiegels 202. Die Brennweite des zweiten Objektivteils 200 im doppelten Durchgang und des Konkavspiegels 202 weist mindestens den dreifachen Wert des freien Durchmessers des Konkavspiegels 202 auf.

Bevorzugt sind die Winkel der Hauptstrahlen wie auch der Randstrahlen zur optischen Achse am Strahlteiler in Luft kleiner als 10°, bevorzugt kleiner als 5°.

Anstelle des Strahlerteilerwürfels wäre auch eine schräggestellte Strahlteilerplatte denkbar.

Besonders bevorzugt ist es, wenn das Strahlteilerprisma derart ausgebildet ist, daß das Seitenverhältnis $A_1$:$B_1$ der zum Objekt 1 zeigenden Fläche im Bereich $0,7 < A_1:B_1 \leq 0.1$ ist. Bevorzugt liegt das Seitenverhältnis $A_2$:$B_2$ der zum dritten Objektivteil hinweisenden Fläche des Strahlteilerprismas im Bereich $0,7 < A_2:B_2 \leq 1.0$.

In Figur 2a ist ein erfindungsgemäßes Projektionsobjektiv dargestellt. Hierbei handelt es sich um ein Projektionsobjektiv mit Zwischenbild Z. Gleiche Bauteile wie in Figur 1 werden mit denselben Bezugsziffern belegt.

Das System gemäß Figur 2a umfaßt einen ersten Objektivteil 100, einen zweiten Objektivteil 200, einen Konkavspiegel 202 sowie einen dritten Objektivteil 300, in dem das Zwischenbild Z zu liegen kommt. Bei dem Projektionsobjektiv handelt es sich um ein 4:1-Reduktionsobjektiv. Anstelle des 4:1-Reduktionsobjektiv wären hier auch Reduktionsobjektive mit einem anderen Abbildungsmaßstab denkbar. Das Objekt - Retikel - liegt bei 1, das Bild auf dem Wafer bei 84. Tabelle 1 gibt die Radien und die Abstände aller optisch wirksamen Flächen 2 - 83 an. Die Flächen 2-5 liegen im ersten Objektivteil 100, die Flächen 6-8 bezeichnen die Strahlteilerflächen beim hinlaufenden Durchtritt, die Flächen 9-18 die Flächen im zweiten Objektivteil 200 im hinlaufenden Durchtritt, die Fläche 19 den Konkavspiegel, die Flächen 20-29 die Flächen im zweiten Objektivteil 200 im rücklaufenden Durchtritt, die Flächen 30-32 die Strahlteilerflächen im rücklaufenden Durchtritt sowie die Flächen 34-35, 37-68 und 70-83 die Flächen im dritten Objektivteil 300. 36 bezeichnet das Zwischenbild und 69 die konjugierte Blende. Der freie Arbeitsabstand beträgt objektseitig (0-1) mehr als 30 mm und waferseitig (83-84) mehr als 5 mm. Die numerische Apertur NA liegt bei 0,7.

Der erste Teilobjektiv 100 umfaßt im dargestellten Ausführungsbeispiel eine Feldlinse 101 mit Flächen 2, 3, die dazu dient, den Hauptstrahl auf den Scheitel des Konkavspielgels zu fokussieren.

Das Ausführungsbeispiel gemäß Fig. 2a umfasst wegen des Zwischenbildes zwei konjugierte Blendenebenen. Eine davon - die Blendenebene B - kommt auf dem Konkavspiegel 202 zu liegen, die zweite Blendenebene B' im dritten Teilobjektiv vor Linsenfläche 70. Da die zweite Blende B' im dritten Objektivteil leicht zugänglich ist, ist sie bevorzugt als Systemblende zu nutzen.

Das Ausführungsbeipiel gemäß Fig.2a ist ausgelegt auf 193 nm Wellenlänge ohne Beschränkung hierauf. Das diesem Ausführungsbeispiel zugrunde liegende Designkonzept kann auch bei anderen Wellenlängen, insbesondere bei 157 nm eingesetzt werden.

Der erste und dritte Objektivteil sind bezüglich der chromatischen Längsaberration (CHL) unterkorrigiert und der zweite Objektivteil im doppelten Durchgang überkorrigiert. Die Unterkorrektion von erstem und drittem Objektivteil werden vom zweiten Objektivteil im vorliegenden Ausführungsbeispiel überkorrigiert. Es gilt:

$$2*(CHL_{Objektivteil\ 2}) = -106\ \%\ *\ (CHL_{Objekfivteil\ 1} + CHL_{Objektivteil\ 3})$$

Der zweite Obektivteil im doppelten Durchgang ist bezüglich der Petzvalsumme überkorrigiert und der erste und dritte Objektivteil unterkorrigiert, wobei gilt:

$$2*(Petzvalsumme_{Objektivteil\ 2}) + Petzvalsumme_{Konkavspiegel} =$$

$$-(90\ bis\ 110)\ \%\ *\ (Petzvalsumme_{Objektivteil\ 1} + Petzvalsumme_{Objektivteil\ 3})$$

Für das in Fig.2a gezeigte Ausführungsbeispiel ergibt sich:

$$2*(Petzvalsumme_{Objektivteil\ 2}) + Petzvalsumme_{Konkavspielgel} = 0,025087$$

und

$$(Petzvalsumme_{Objektivteil\ 1} + Petzvalsumme_{Objektivteil\ 3}) = -\ 0,025094$$

d.h. die Unterkorrektion von erstem und drittem Objektivteil wird zu mindestens 90 % durch die Überkorrektion von zweitem Objektivteil und Konkavspiegel kompensiert.

Die Brechkraft des Konkavspiegels beträgt 0,01488 mm$^{-1}$, die Brechkraft des zweiten Objektivteils -0,00866 mm$^{-1}$. Die Brennweite des zweiten Objektivteils 200 im doppelten Durchgang und des Konkavspiegelsa 202 ist in vorliegendem Ausführungsbeispiel 622,8 mm; der freie Durchmesser des Konkavspiegels ungefähr 100 mm.

Der Abbildungsmaßstab des Projektionsobjektives bis zum Zwischenbild beträgt $\beta_{zm}=1,5$.

Zur leichteren Korrektur von Abbildungsfehlern ist das gesamte Projektionsobjektiv als ein sogenanntes On-Axis-System konzipiert, d.h. die Hauptstrahlen sind symmetrisch zur Hauptachse HA des Systems.

Um die Baulänge von ca. 1,1 m des Objektives zu verkürzen, kann in einer weiteren Ausführungsform der Erfindung vorgesehen sein, einen Umlenkspiegel nach dem Strahlteiler und vor dem Zwischenbild Z anzuordnen. Auch das Einbringen eines Umlenkspiegels vor dem Strahlteiler wäre denkbar. Durch das Einbringen eines Umlenkspiegels können Retikel-und Waferlage parallelisiert werden.

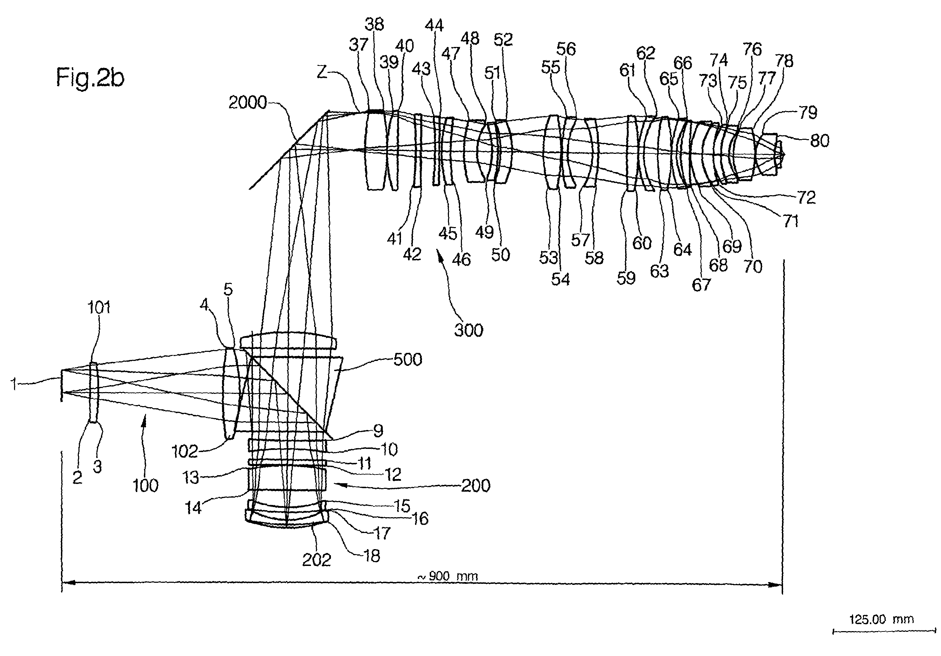

Eine solche Ausführungsform ist in Figur 2b dargestellt. Gleiche Bauteile wie in Figur 2a, insbesondere gleiche Linsenflächen, sind mit denselben Bezugsziffern belegt. Deutlich zu erkennen der Umlenkspiegel 2000. Die Gesamtlänge dieser Ausführungsform beträgt ungefähr 0,9m.

Die numerische Apertur des in Fig. 2b dargestellten Projektionsobjektives beträgt ebenfalls NA = 0,7.
Tabelle 1 gibt die Werte eines beispielhaften, erfindungsgemäßen Linsensystems gemäß Fig. 2a an, wobei unter die laufende Nummer die Nummer der Systemfläche bzw. Linsenfläche, die mit den Bezugsziffern in Fig 2a und 2b korreliert, unter "Radius" deren Radius, unter "Dicke" deren Dicke sowie unter "Glas" das verwendete Material zu verstehen ist. $SiO_2$ ist dabei Quarzglas, $CaF_2$ ist Kalziumfluorid-Einkristall.

| laufende Nummer | Radius | Dicke | Glas |
|---|---|---|---|
|  | Infinity | 35.000 |  |
| 1 | Infinity | 0.000 |  |
| 2 | Infinity | 10.000 | $SiO_2$ |
| 3 | -356.062 | 157.473 |  |
| 4 | 452.316 | 20.000 | $SiO_2$ |
| 5 | -207.509 | 15.494 |  |
| 6 | Infinity | 46.000 | $SiO_2$ |
| 7 | Infinity | -46.000 | $SiO_2$ |
| 8 | Infinity | -11.450 |  |
| 9 | 714.294 | -10.000 | $SiO_2$ |
| 10 | -233.153 | -14.053 |  |
| 11 | 11257.822 | -7.319 | $SiO_2$ |
| 12 | 5681.926 | -0.267 |  |
| 13 | -294.457 | -29.996 | $SiO_2$ |
| 14 | 2624.912 | -21.085 |  |
| 15 | 118.549 | -6.000 | $SiO_2$ |
| 16 | 372.661 | -9.645 |  |
| 17 | 89.531 | -6.000 | $SiO_2$ |
| 18 | 220.679 | -3.803 |  |
| 19 | 134.415 | 3.803 |  |
| 20 | 220.679 | 6.000 | $SiO_2$ |
| 21 | 89.531 | 9.645 |  |
| 22 | 372.661 | 6.000 | $SiO_2$ |
| 23 | 118.549 | 21.085 |  |
| 24 | 2624.912 | 29.996 | $SiO_2$ |
| 25 | -294.457 | 0.267 |  |
| 26 | 5681.926 | 7.319 | $SiO_2$ |
| 27 | 11257.822 | 14.053 |  |
| 28 | -233.153 | 10.000 | $SiO_2$ |
| 29 | 714.294 | 11.450 |  |
| 30 | Infinity | 46.000 | $SiO_2$ |
| 31 | Infinity | 46.000 | $SiO_2$ |
| 32 | Infinity | 0.000 |  |
| 33 | Infinity | 11.000 |  |
| 34 | -6197.720 | 20.000 | $SiO_2$ |

(fortgesetzt)

| laufende Nummer | Radius | Dicke | Glas |
|---|---|---|---|
| 35 | -220.468 | 289.683 | |
| 36 | Infinity | 35.000 | |
| 37 | 283.114 | 27.145 | $SiO_2$ |
| 38 | -291.549 | 0.100 | |
| 39 | 169.089 | 12.856 | $SiO_2$ |
| 40 | 2565.581 | 24.511 | |
| 41 | -380.925 | 6.000 | $SiO_2$ |
| 42 | -3955.807 | 18.475 | |
| 43 | -360.725 | 6.000 | $SiO_2$ |
| 44 | -890.059 | 2.723 | |
| 45 | 179.574 | 11.560 | $SiO_2$ |
| 46 | 339.906 | 16.696 | |
| 47 | 147.862 | 16.312 | $SiO_2$ |
| 48 | 65.737 | 18.352 | |
| 49 | -103.682 | 7.718 | $SiO_2$ |
| 50 | -197.447 | 2.785 | |
| 51 | -111.946 | 15.000 | $SiO_2$ |
| 52 | -106.336 | 38.908 | |
| 53 | 152.811 | 22.411 | $SiO_2$ |
| 54 | -194.069 | 0.375 | |
| 55 | 199.667 | 7.318 | $SiO_2$ |
| 56 | 93.342 | 30.484 | |
| 57 | -89.837 | 7.125 | $SiO_2$ |
| 58 | -197.820 | 35.858 | |
| 59 | 713.001 | 13.228 | $SiO_2$ |
| 60 | -274.158 | 0.375 | |
| 61 | 106.260 | 6.375 | $SiO_2$ |
| 62 | 76.991 | 18.205 | |
| 63 | 207.243 | 16.125 | $SiO_2$ |
| 64 | -265.976 | 0.375 | |
| 65 | 105.981 | 6.937 | $SiO_2$ |
| 66 | 70.150 | 5.069 | |
| 67 | 110.354 | 11.250 | $SiO_2$ |
| 68 | 337.355 | 1.500 | |
| 69 | Infinity | 0.000 | |
| 70 | 83.053 | 13.500 | $SiO_2$ |
| 71 | 64.019 | 0.100 | |
| 72 | 60.890 | 13.500 | $SiO_2$ |

(fortgesetzt)

| laufende Nummer | Radius | Dicke | Glas |
|---|---|---|---|
| 73 | 102.439 | 0.100 | |
| 74 | 65.465 | 8.392 | SiO$_2$ |
| 75 | 75.287 | 0.523 | |
| 76 | 74.115 | 10.249 | SiO$_2$ |
| 77 | 48.411 | 4.971 | |
| 78 | 70.660 | 26.249 | SiO$_2$ |
| 79 | -135.364 | 0.037 | |
| 80 | 38.280 | 23.827 | CaF$_2$ |
| 81 | 41.066 | 0.037 | |
| 82 | 46.927 | 9.291 | CaF$_2$ |
| 83 | -187.500 | 5.625 | |
| 84 | Infinity | 0.000 | |
| IMG: | Infinity | 0.000 | |

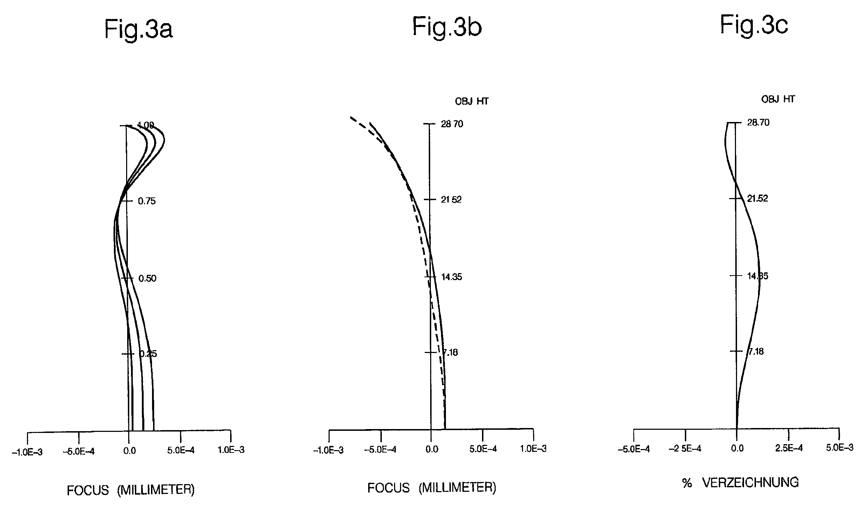

Figur 3a zeigt die sich für das Ausführungsbeispiel gemäß Tabelle 1 ergebende longitudinale sphärische Aberration, Figur 3b den Astigmatismus in Abhängigkeit von der Höhe des Objektes und Figur 3c die Verzeichnung in Abhängigkeit von der Objekthöhe.

Das Ausführungsbeispiel wurde wie oben beschrieben chromatisch durch Negativlinsen mit großer Strahlhöhe vor dem Konkavspiegel korrigiert sowie dem Einsatz eines zweiten Materials. Erreicht wurde dadurch ein sehr breitbandiges Design für 193 nm, d.h. bei einer Bandbreite von $\Delta\lambda$ = 20 pm beträgt die chromatische Längsabweichung nur 0,22 μm. Auch bei Einsatz von nur einem Material, z.B. CaF$_2$ bei 157 nm kann gegenüber einem rein refraktiven System alleine durch die Negativlinsen vor dem Spiegel eine vergleichsweise große Bandbreite erreicht werden.

Für ein On-Axis-System wurde erstmals ein Projektionsobjektiv angegeben bei dem die Nachteile bekannter Systeme mit physikalischen Strahlteiler vermieden werden. Insbesondere zeichnet sich das System dadurch aus, daß die Korrektur des Farblängsfehlers CHL nicht mehr limitiert ist, der Arbeitsabstand sowohl zwischen Objektebene und erstem Objektivteil sowie zwischen drittem Objektivteil und der Bildebene für eine Anwendung in der Mikrolithographie ausreichend ist und auf der Strahlteilerfläche ein doppelt paralleler Strahlengang sowohl beim Durchtritt zum Konkavspiegel wie auch beim Rücklauf vom Konkavspiegel realisiert wird.

**Patentansprüche**

1. Katadioptrisches Projektionsobjektiv mit

    1.1 einer Objektebene (1),
    1.2 einem physikalischen Strahlteiler (500),
    1.3 einem Konkavspiegel (202),
    1.4 einer Bildebene (84),
    1.5 einem ersten Objektivteil (100), wobei der erste Objektivteil zwischen Objektebene (1) und physikalischem Strahlteiler (500) angeordnet ist,
    1.6 einem zweiten Objektivteil (200), wobei der zweite Objektivteil (200) zwischen physikalischem Strahlteiler (500) und Konkavspiegel (202), angeordnet ist
    1.7 einem dritten Objektivteil (300), wobei der dritte Objektivteil (300) zwischen physikalischem Strahlteiler (500) und der Bildebene (84) angeordnet ist,
    dadurch gekennzeichnet, daß
    1.8 der zweite Objektivteil (200) wenigstens zwei Zerstreulinsen umfaßt.

2. Katadioptrisches Projektionsobjektiv mit

2.1 einer Objektebene (1),

2.2 einem physikalischen Strahlteiler (500),

2.3 einem Konkavspiegel (202),

2.4 einer Bildebene (84),

2.5 einem ersten Objektivteil (100), wobei der erste Objektivteil (100) zwischen Objektebene (1) und physikalischem Strahlteiler (500) angeordnet ist,

2.6 einem zweiten Objektivteil (200), wobei der zweite Objektivteil (200) zwischen physikalischem Strahlteiler (500) und Konkavspiegel (202) angeordnet ist,

2.7 einem dritten Objektivteil (300), wobei der dritte Objektivteil (300) zwischen physikalischem Strahlteiler (500) und der Bildebene (84) angeordnet ist,

dadurch gekennzeichnet, daß

2.8 der zweite Objektivteil (200) bezüglich der chromatischen Längsaberration CHL überkorrigiert ist und der erste und dritte Objektivteil unterkorrigiert sind und die Überkorrektur des zweiten Objektivteils im doppelten Durchgang die Unterkorrektur von erstem und drittem Objektivteil zu mindestens 70% vorzugsweise mehr als 85 % kompensiert.

3. Katadioptrisches Projektionsobjektiv nach Anspruch 1, dadurch gekennzeichnet, daß die Zerstreulinsen im zweiten Objektivteil (200) räumlich getrennt sind.

4. Katadioptrisches Projektionsobjektiv nach einem der Ansprüche 1 bis 3 , dadurch gekennzeichnet, daß die Brechkraft des zweiten Objektivteiles (200) negativ ist.

5. Katadioptrisches Projektionsobjektiv nach Anspruch 4, dadurch gekennzeichnet, daß die Brechkraft des zweiten Objektivteils 40 bis 80 % der Brechkraft des Konkavspiegels (202) beträgt.

6. Katadioptrisches Projektionsobjektiv nach einem der Ansprüche 1 bis 5, dadurch gekennzeichnet, daß der zweite Objektivteil (200) wenigstens eine Positivlinse umfaßt.

7. Katadioptrisches Projektionsobjektiv nach Anspruch 6, dadurch gekennzeichnet, daß die Positivlinse zwischen den Negativlinsen des zweiten Objektivteils (200) angeordnet ist.

8. Katadioptrisches Projektionsobjektiv nach einem der Ansprüche 1 bis 7, dadurch gekennzeichnet, daß die Blendenebene im zweiten Objektivteil (200) liegt.

9. Katadioptrisches Projektionsobjektiv nach einem der Ansprüche 1 bis 7 dadurch gekennzeichnet, daß die Blendenebene auf dem Konkavspiegel liegt.

10. Katadioptrisches Projektionsobjektiv nach einem der Ansprüche 1 bis 9, dadurch gekennzeichnet, daß der erste Objektivteil (100) positive Brechkraft aufweist.

11. Katadioptrisches Projektionsobjektiv nach einem der Ansprüche 1 bis 10, dadurch gekennzeichnet, daß der dritte Objektivteil (300) positive Brechkraft aufweist.

12. Katadioptrisches Projektionsobjektiv nach einem der Ansprüche 1 bis 11, dadurch gekennzeichnet, daß die Winkel der Hauptstrahlen als auch der Randstrahlen zur optischen Achse am physikalischen Strahlteiler (500) in Luft kleiner als 10°, vorzugsweise kleiner als 5° sind.

13. Katadioptrisches Projektionsobjektiv nach einem der Ansprüche 1 bis 12, dadurch gekennzeichnet, daß die Brennweite des zweiten Objektivteils (200) im doppelten Durchgang und des Konkavspiegels (202) mindestens den dreifachen Wert des freien Durchmessers des Konkavspielgels hat.

14. Katadioptrisches Projektionsobjektiv nach einem der Ansprüche 1 bis 13, dadurch gekennzeichnet, daß für die Petzvalsumme des Projektionsobjektives gilt:
Petzvalsumme (2x zweiter Objektivteil und Konkavspiegel) = -0,9 bis -1,1 der (Petzvalsumme (erster Objektivteil) + Petzvalsumme (dritter Objektivteil)).

15. Katadioptrisches Projektionsobjektiv nach einem der Ansprüche 1 bis 13, dadurch gekennzeichnet, daß der zweite Objektivteil bezüglich der Petzvalsumme im doppelten Durchgang überkorrigiert ist und der erste und dritte Objektivteil unterkorrigiert sind und die Überkorrektur des zweiten Objektivteils die Unterkorrektur von erstem und drittem Objektivteil zu mindestens 90% kompensiert.

16. Katadioptrisches Projektionsobjektiv nach einem der Ansprüche 1 bis 15, dadurch gekennzeichnet, daß der Arbeitsabstand vom dritten Objektivteil (300) zur Bildebene (84) > 5 mm ist.

17. Katadioptrisches Projektionsobjektiv nach einem der Ansprüche 1 bis 16, dadurch gekennzeichnet, daß der dritte Objektivteil (300) refraktiv ausgebildet ist.

18. Katadioptrisches Projektionsobjektiv nach einem der Ansprüche 1-17, dadurch gekennzeichnet, daß das Projektionsobjektiv ein Objektiv mit Verkleinerung $\beta$, insbesondere ein 4:1 oder 6:1-Objektiv ist.

19. Katadioptrisches Projektionsobjektiv nach einem der Ansprüche 1 bis 18, dadurch gekennzeichnet, daß die Blendenebene (B') zugänglich im dritten Objektivteil zum liegen kommt.

20. Katadioptrisches Projektionsobjektiv nach einem der Ansprüche 1 bis 19, dadurch gekennzeichnet, daß die optische Achse (HA) des Systems das Objekt durchstößt.

21. Katadioptrisches Projektionsobjektiv nach einem der Ansprüche 1 bis 20, dadurch gekennzeichnet, daß das System ein um die optische Achse (HA) zentriertes System ist.

22. Katadioptrisches Projektionsobjektiv nach einem der Ansprüche 1 bis 21, dadurch gekennzeichnet, daß die Hauptstrahlen in der Objektebene unter $0°\pm 20$ mrad verlaufen.

23. Katadioptrisches Projektionsobjektiv nach einem der Ansprüche 1 bis 22, dadurch gekennzeichnet, daß der erste Objektivteil (100) wenigstens eine positive Feldlinse umfaßt.

24. Katadioptrisches Projektionsobjektiv nach einem der Ansprüche 1 bis 23, dadurch gekennzeichnet, daß das Projektionsobjektiv wenigstens einen Umlenkspiegel (2000) umfaßt.

25. Katadioptrisches Projektionsobjektiv nach Anspruch 24, dadurch gekennzeichnet, daß ein Umlenkspiegel (2000) vor dem physikalischen Strahlteiler (500) im ersten Objektivteil (100) angeordnet ist.

26. Katadioptrisches Projektionsobjektiv nach Anspruch 24, dadurch gekennzeichnet, daß ein Umlenkspiegel (2000) nach dem physikalischen Strahlteiler im dritten Objektivteil (300) angeordnet ist.

27. Katadioptrisches Projektionsobjektiv nach einem der Ansprüche 1 bis 26, dadurch gekennzeichnet, daß das Projektionsobjektiv asphärische Flächen umfaßt.

28. Katadioptrisches Projektionsobjektiv nach einem der Ansprüche 1 bis 27, dadurch gekennzeichnet, daß der physikalische Strahlteiler (500) ein Strahlteilerprisma mit polarisationsabhängigem, reflektierendem Schichtsystem ist.

29. Katadioptrisches Projektionsobjektiv nach einem der Ansprüche 1 bis 27, dadurch gekennzeichnet, daß der physikalische Strahlteiler (500) ein Strahlteilerprisma mit polarisationsabhängigem, transmittierendem Schichtsystem ist.

30. Katadioptrisches Projektionsobjektiv nach einem der Ansprüche 1 bis 27, dadurch gekennzeichnet, daß der physikalische Strahlteiler (500) eine schräggestellte Platte, vorzugsweise eine $\lambda$/4-Platte ist.

31. Katadioptrisches Projektionsobjektiv nach einem der Ansprüche 1 bis 30, dadurch gekennzeichnet, daß der Footprint in der Nähe des physikalischen Strahlteilers (500) ein Seitenverhältnis A : B im Bereich 0,7 < A : B ≤ 1.0 umfaßt.

32. Katadioptrisches Projektionsobjektiv nach einem der Ansprüche 1 bis 31, dadurch gekennzeichnet, daß der dritte Objektivteil (300) ein Zwischenbild (Z) aufweist.

**33.** Katadioptrisches Projektionsobjektiv mit

33.1 einer Objektebene (1),
33.2 einem physikalischen Strahlteiler (500),
33.3 einem Konkavspiegel (202),
33.4 einer Bildebene (84),
33.5 einem ersten Objektivteil (100), wobei der erste Objektivteil (100) zwischen Objektebene (1) und physikalischem Strahlteiler (500) angeordnet ist,
33.6 einem zweiten Objektivteil (200), wobei der zweite Objektivteil (200) zwischen physikalischem Strahlteiler (500) und Konkavspiegel (202) angeordnet ist,
33.7 einem dritten Objektivteil (300), wobei der dritte Objektivteil (300) zwischen physikalischem Strahlteiler (500) und der Bildebene (84) angeordnet ist dadurch gekennzeichnet, daß
33.8 der dritte Objektivteil (300) ein Zwischenbild (Z) aufweist.

**34.** Katadioptrisches Projektionsobjektiv nach Anspruch 32 oder 33, dadurch gekennzeichnet, daß
das Zwischenbild im dritten Objektivteil (300) zwei Objektivteile voneinander trennt.

**35.** Katadioptrisches Projektionsobjektiv nach einem der Ansprüche 32 bis 34, dadurch gekennzeichnet, daß
der Abbildungsmaßstab des katadioptirischen Projektionsobjektives von der Objektebene bis zum Zwischenbild im Bereich 1,0±0,7 liegt.

**36.** Katadioptrisches Projektionsobjektiv nach Anspruch 34 oder 35, dadurch gekennzeichnet, daß
der im dritten Objektivteil (300) vor dem Zwischenbild (Z) angeordnete Objektivteil positive Brechkraft aufweist.

**37.** Katadioptrisches Projektionsobjektiv nach einem der Ansprüche 32 bis 36, dadurch gekennzeichnet, daß
der im dritten Objektivteil (300) nach dem Zwischenbild (Z) angeordnete Objektivteil ein verkleinernder Objektivteil ist.

**38.** Katadioptrisches Projektionsobjektiv nach einem der Ansprüche 32 bis 37, dadurch gekennzeichnet, daß
der im dritten Objektivteil (300) nach dem Zwischenbild (Z) angeordnete Objektivteil asphärische Flächen umfaßt.

**39.** Katadioptrisches Projektionsobjektiv nach einem der Ansprüche 32 bis 38, dadurch gekennzeichnet, daß
der im dritten Objektivteil (300) nach dem Zwischenbild (Z) angeordnete Objektivteil eine konjugierte Blendenebene (B') umfaßt.

**40.** Katadioptrisches Projektionsobjektiv nach Anspruch 39,
dadurch gekennzeichnet, daß
der größere Durchmesser der beiden konjugierten Blendenebenen um höchstens einen Faktor 1,5 größer ist als der kleinere der beiden Blendendurchmesser.

**41.** Katadioptrisches Projektionsobjektiv nach einem der Ansprüche 1 bis 40, dadurch gekennzeichnet, daß
das Objektiv objekt- und/oder bildseitig telezentrisch ausgebildet ist.

**42.** Katadioptrisches Projektionsobjektiv nach einem der Ansprüche 1 bis 41, dadurch gekennzeichnet, daß
das Objektiv nur ein Linsenmaterial umfasst.

**43.** Katadioptrisches Projektionsobjektiv nach einem der Ansprüche 1 bis 42, dadurch gekennzeichnet, daß
als Linsenmaterial nachfolgende Materialien Verwendung finden:

für $180 \leq \lambda \leq 250$ nm $SiO_2$; insbsondere 193nm, 248 nm
für $150 \leq \lambda < 200$ nm $CaF_2$; insbesondere 157 nm, 193 nm
für $\lambda < 160$ nm Alkalifluoride; insbeosndere für 157 nm

**44.** Katadioptrisches Projektionsobjektiv nach einem der Ansprüche 1 bis 41, dadurch gekennzeichnet, daß
für Wellenlängen

$150 \leq \lambda \leq 250$ nm, insbesondere 157 nm, 193 nm, 248 nm,
$SiO_2$ und/oder $CaF_2$ und/oder BaF

als Linsenmaterialien Verwendung finden.

45. Projektionsbelichtungsanlage für die Mikrolithographie dadurch gekennzeichnet, daß die Anlage ein katadioptrisches Projektionsobjektiv gemäß einem der Ansprüche 1 bis 44 umfaßt.

46. Verfahren zur Chipherstellung mit einer Projektionsbelichtungsanlage gemäß Anspruch 45.

Fig.1

Fig.2a

Fig.2b

Fig.3a

Fig.3b

Fig.3c

FOCUS (MILLIMETER)

FOCUS (MILLIMETER)

% VERZEICHNUNG

EP 1 102 100 A2